# EUROPEAN PATENT APPLICATION

(11) **EP 4 811 659 A1**
(43) Date of publication of application: **23.09.2026**
(21) Application number: 26163211.1
(22) Date of filing: 09.03.2026
(51) Int. Cl.: H03K 3/013

(54) **LOW PHASE NOISE SIGNAL GENERATION CIRCUITRY**

(30) Priority: 21.03.2025 US 202519086590
(71) Applicant: NXP USA, Inc, Austin, TX 78735 (US)
(72) Inventor: Wang, Lantao, 5656AG Eindhoven (NL); Belchev, Totyo Penchev, 5656AG Eindhoven (NL); Mora Sanchez, Rodrigo Alexander, 5656AG Eindhoven (NL)
(74) Representative: Schwarzweller, Thomas

(57) **Abstract**

The present disclosure relates to signal generation circuitry that includes first square wave conversion circuitry including a first input and a first output and second square wave conversion circuitry comprising a second input and a second output. The second output is coupled to the first input of the first square wave conversion circuitry, and the square wave conversion circuitry is configured to generate a first square wave based on a first oscillating signal received at the second input. The first square wave and a second oscillating signal are combined to produce a combined signal, and wherein the first square wave conversion circuitry is configured to generate a second square wave based on the combined signal.

## Description

### TECHNICAL FIELD

Embodiments of the subject matter described herein relate generally to signal generation circuitry, including signal generation circuitry for generating square waves using square wave conversion circuitry.

### BACKGROUND

Modern applications for wireless signal transmission/reception, such as mobile telecommunication, radio, or radar, typically have low phase noise requirements for clock or local oscillator (LO) signal generation in order to achieve better signal-to-noise specifications. Radio-frequency (RF) oscillators are commonly used in phase locked loops (PLLs), and are typically supplied with a lower frequency reference signal. Such reference signals are commonly provided as square waves.

### BRIEF DESCRIPTION OF DRAWINGS

A more complete understanding of the subject matter may be derived by referring to the detailed description and claims when considered in conjunction with the following figures, wherein like reference numbers refer to similar elements throughout the figures. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:

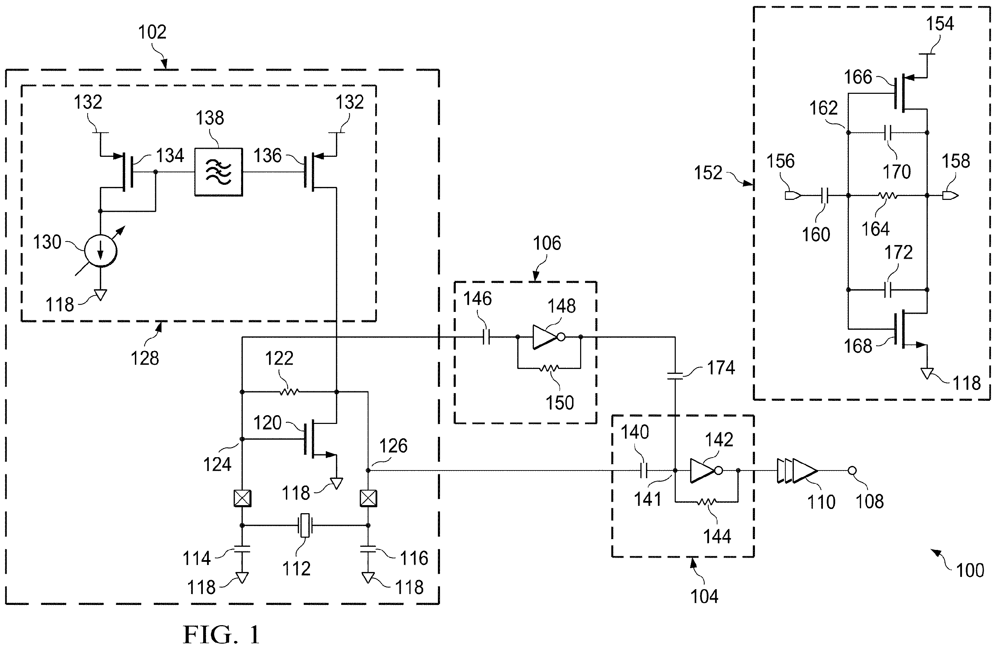

FIG. 1 shows an illustrative circuit diagram that includes signal generation circuitry configured to generate and provide a square wave, in accordance with various embodiments;

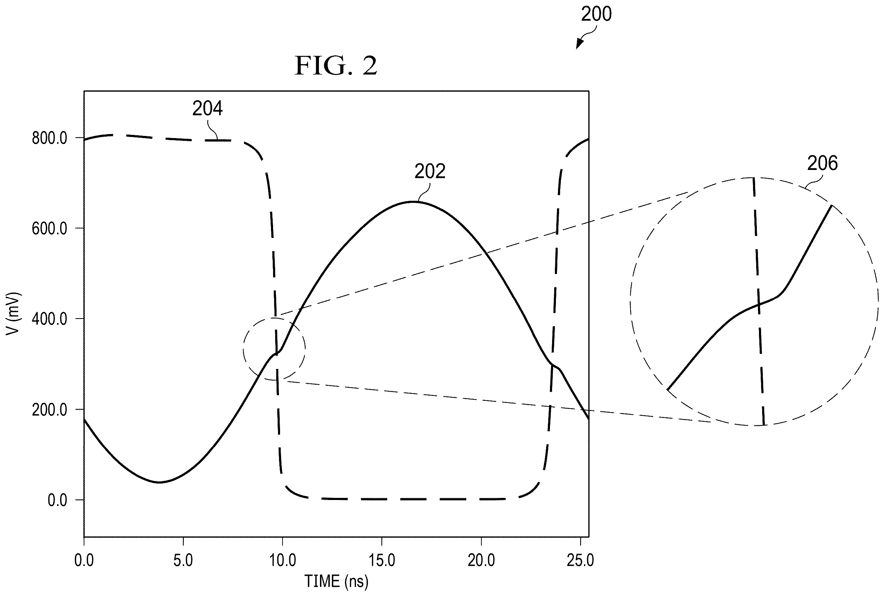

FIG. 2 shows an illustrative graph representing signals generated by signal generation circuitry having only a single set of square wave conversion circuitry, including input and output signals of the square wave conversion circuitry;

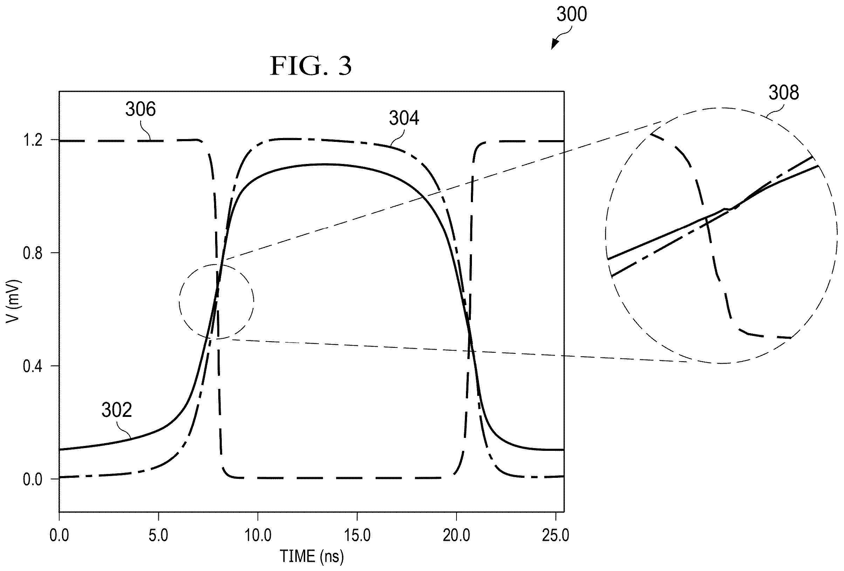

FIG. 3 shows an illustrative graph representing signals generated by in signal generation circuitry such as the signal generation circuitry of FIG. 1, including an input signal provided at the input of first square wave conversion circuitry, a first square wave output by second square wave conversion circuitry, and a second square wave output by the first square wave conversion circuitry, in accordance with various embodiments; and

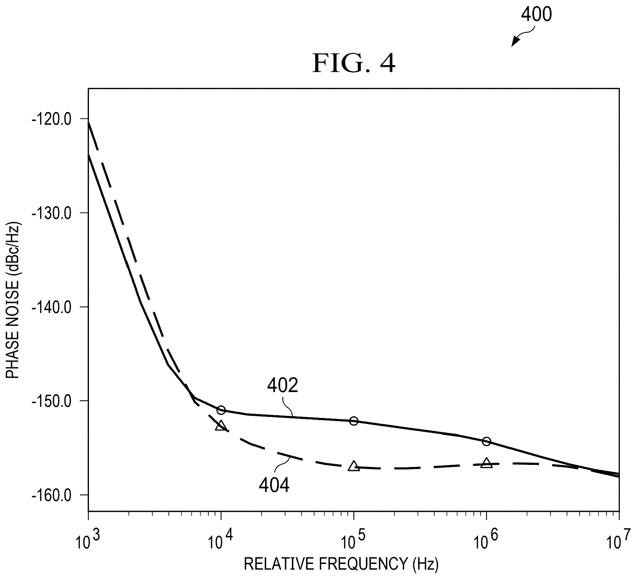

FIG. 4 shows an illustrative graph representing phase noise versus relative frequency offset for a first square wave signal generated by signal generation circuitry having only a single set of square wave conversion circuitry and for a second square wave signal generated by signal generation circuitry having two sets of square wave conversion circuitry, such as the signal generation circuitry of FIG. 1, in accordance with various embodiments.

### DETAILED DESCRIPTION

The following detailed description is merely illustrative in nature and is not intended to limit the embodiments described herein and uses of such embodiments. Furthermore, there is no intention to be bound by any expressed or implied theory presented in the preceding technical field, background, or the following detailed description.

For simplicity and clarity of illustration, the figures illustrate the general manner of construction. Descriptions and details of well-known features and techniques may be omitted from the following detailed description to avoid unnecessarily obscuring the present disclosure. For example, the dimensions of some of the elements or regions in the figures may be exaggerated relative to other elements or regions to help improve understanding of embodiments described herein.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. As used herein the terms "approximate," "approximately," "substantial" and "substantially" mean sufficient to accomplish the stated purpose in a practical manner and that minor imperfections, if any, are not significant for the stated purpose.

Along these lines, when used with references to measurable quantities including, but not limited to, dimensions, these terms mean that the quantities are equal to the values stated subject to accepted tolerances of any methods or apparatus chosen to fabricate the described structures or measure the quantities or dimensions described. Directional references such as "top," "bottom," "left," "right," "above," "below," and so forth, unless otherwise stated, are not intended to require any preferred orientation and are made with reference to the orientation of the corresponding figure or figures for purposes of illustration. As used herein, the words "exemplary" and "example" mean "serving as an example, instance, or illustration." Any implementation described herein as exemplary or an example is not necessarily to be construed as preferred or advantageous over other implementations. In addition, certain terms may also be used herein for reference only, and thus are not intended to be limiting.

Herein, elements or nodes or features are sometimes referred to as being "connected" or "coupled" together. As used herein, unless expressly stated otherwise, "connected" means that one element is directly joined to (or directly communicates with) another element in an electrical or non-electrical manner, and not necessarily mechanically. Likewise, unless expressly stated otherwise, "coupled" means that one element is directly or indirectly joined to (or directly or indirectly communicates with) another element in an electrical or non-electrical manner, and not necessarily mechanically. Thus, although the schematic illustrations shown in the figures depict exemplary arrangements of elements, additional intervening elements, devices, features, or components may be present in one or more embodiments of the depicted subject matter.

Various embodiments described herein relate to signal generation circuitry for producing a square wave with low phase noise, which may be used as a reference signal (e.g., a reference clock signal) in applications in which low phase noise is desirable or required. The signal generation circuitry may have an output, oscillator circuitry, first square wave conversion circuitry (sometimes referred to herein as "first conversion circuitry"), and second square wave conversion circuitry (sometimes referred to herein as "second conversion circuitry"). The second conversion circuitry is coupled in parallel with the oscillator circuitry (e.g., in parallel with a resonator thereof), produces a first square wave based on an oscillating signal output by the oscillator circuitry, and provides the first square wave to the first conversion circuitry. The first conversion circuitry receives an oscillating signal from the oscillator circuitry and the first square wave from the second conversion circuitry, and generates a second square wave, and provides the second square wave at the output of the signal generation circuitry. The first square wave output by the second conversion circuitry counteracts the kickback effect of the first conversion circuitry on the resonator of the oscillator circuitry while also mitigating phase noise.

Conventional signal generation circuitry that produces a square wave reference signal typically includes only a single square wave conversion circuit that is connected directly between an oscillator and the output of the signal generation circuitry. In such conventional arrangements, the limiting factor for phase noise performance tends to be the square wave conversion circuit. Lower phase noise is typically desirable in modern radio frequency (RF) applications such as wireless communications and radar.

Embodiments herein address these challenges by implementing both first square wave conversion circuitry that provides a square wave at the output of the signal generation circuitry in combination with additional ("second") square wave conversion circuitry that is coupled in parallel with a resonator (e.g., "piezoelectric resonator", "crystal oscillator", or "quartz crystal" as non-limiting examples) of the oscillator circuitry. The second conversion circuitry generates a square wave based on a first oscillating signal provided by the oscillator circuitry, and combines that square wave with a second oscillating signal provided by the oscillator circuitry at the input of the first conversion circuitry. In this way, the second conversion circuitry increases the slope (i.e., increases the steepness of the slope) of the oscillating signal provided by the oscillator circuitry without excessive loading (i.e., increasing the load capacitance of) the resonator. The phase noise of the output signal (i.e., square wave) provided by the first conversion circuitry is inversely proportional to the steepness of the input signal provided to the input of the first conversion circuitry. Thus, by increasing the steepness of the slope of the oscillating signal using the second conversion circuitry, the phase noise in the square wave signal output by the signal generation circuitry is advantageously reduced.

In one or more embodiments, signal generation circuitry includes oscillator circuitry, first square wave conversion circuitry ("first conversion circuitry"), second square wave conversion circuitry ("second conversion circuitry"), and an output node. The first conversion circuitry may be coupled between a first node of the oscillator circuitry and an output node of the signal generation circuitry. The second conversion circuitry may be coupled between the first node of the oscillator circuitry and a second node of the oscillator circuitry.

In one or more embodiments, the oscillator circuitry may include a Pierce oscillator circuit. In one or more embodies, the oscillator circuitry may include a resonator, such as a crystal oscillator, first and second capacitances, a transistor, a resistance, and bias circuitry. The resonator may have a first terminal connected to a first node and a second terminal connected to a second node. The first capacitance may be connected between the first node and a reference node. The second capacitance may be connected between the second node and the reference node. The resistance may be connected between the first node and the second node. The transistor may have a gate terminal connected to the first node, a source terminal connected to the reference node, and a drain terminal connected to the second node. The bias circuitry may be connected to the second node. The bias circuitry may include a current mirror that includes a pair of transistors, where gate terminals of the pair of transistors are connected via a low-pass filter.

In one or more embodiments, the first conversion circuitry and the second conversion circuitry may each include an input node, an intermediate node, an output node, a capacitance connected between the intermediate node and the input node, a resistance connected between the intermediate node and the output node, a first transistor having a source terminal coupled to a voltage source, a gate terminal connected to the intermediate node, and a drain terminal connected to the output node, and a second transistor having a source terminal connected to a reference node, a gate terminal connected to the intermediate node, and a drain terminal connected to the output node. The first and second transistors may be arranged to form an inverter. In one or more embodiments, the size of the transistors of the inverter of the first conversion circuitry may be different from the size of the transistors of the inverter of the second conversion circuitry.

In one or more embodiments, the first conversion circuitry may convert an input oscillating signal into a square wave (e.g., generating the square wave based on the oscillating signal). The second conversion circuitry may convert an input oscillating signal into a square wave. The input oscillating signal provided at the input of the second conversion circuitry may be a first oscillating signal generated by the oscillating circuitry. The input oscillating signal provided at the input of the first conversion circuitry may be the sum of a second oscillating signal generated by the oscillating circuitry and the square wave provided by the second conversion circuitry. Combining the square wave produced by the second conversion circuitry with the second oscillating signal generated by the oscillating circuitry at the input of the first conversion circuitry in this way counteracts the kickback effect of the first conversion circuitry on the resonator of the oscillator circuitry while also mitigating phase noise.

FIG. 1 shows an illustrative circuit diagram representing signal generation circuitry 100, which may be configured to generate a square wave (e.g., a square wave reference signal or clock signal) having low phase noise (e.g., less than -150 dBc/Hz for an oscillation frequency of 40 MHz, as a non-limiting example; additional examples are shown in FIG. 4). As shown, the signal generation circuitry 100 includes oscillator circuitry 102, first square wave conversion circuitry 104 (sometimes referred to herein as "first conversion circuitry 104"), second square wave conversion circuitry 106 (sometimes referred to herein as "second conversion circuitry 106"), buffer circuitry 110, and an output node 108.

The oscillator circuitry 102 may include a resonator 112, capacitances 114 and 116, a transistor 120, a resistance 122, nodes 124 and 126, and a bias circuitry 128. The resonator 112 may be a piezoelectric resonator, such as a crystal oscillator. The resonator 112 may have a first terminal coupled to the node 124 and a second terminal coupled to the node 126. The capacitance 114 may be connected between the node 124 and a reference node 118 Herein, a "reference node" refers to a node at which a reference voltage, ground voltage, or common voltage is supplied, in accordance with various embodiments. The capacitance 116 may be connected between the node 126 and the reference node 118. The transistor 120 may have a gate terminal that is connected to the node 124, a source terminal that is coupled to the reference node 118, and a drain terminal that is connected to the node 126. The resistance 122 may be connected between the gate and drain terminals of the transistor 120 (e.g., between the node 124 and the node 126), such that the transistor 120 may be biased via the resistance 122.

The bias circuitry 128 may be configured to provide a DC bias to the transistor 120. The bias circuitry 128 may include a variable current source 130 and a current mirror that includes a transistor 134, a transistor 136, and a low-pass filter 138. The transistor 134 is a diode-connected transistor, having a gate terminal that is connected to its drain terminal. The transistor 134 includes a source terminal that is coupled to a voltage supply 132. The drain terminal of the transistor 134 is connected to a variable current source 130. The transistor 136 includes a source terminal that is coupled to the voltage supply 132 and a drain terminal that is coupled to the node 126. The low-pass filter 138 may be coupled between the gate terminal of the transistor 134 and the gate terminal of the transistor 136. In one or more embodiments, the low-pass filter 138 may have a cut-off frequency of around 1 kHz. Interposing the low-pass filter 138 between the gate terminals of the transistors 134 and 136 in this way may block or mitigate noise (e.g., high, medium and relatively low frequency noise) from the variable current source 130 that might otherwise negatively impact the quality of the oscillating waveforms provided by the oscillating circuitry 102 at nodes 124 and 126.

Due to the current mirror arrangement of the transistors 134 and 136, the electrical current at the drain terminal of the transistor 136 may be proportional to the electrical current at the drain terminal of the transistor 134. In this way, the current provided by the transistor 136 to the rest of the oscillator circuitry 102 via the node 126 may be controlled by, for example, the variable current source 130.

In one or more embodiments, the transistor 134 and the transistor 136 may be p-type metal oxide semiconductor field effect transistors (MOSFETS). In one or more embodiments, the transistor 120 may be an n-type MOSFET. It should be understood that the depiction of the transistors 120, 134, and 136 as MOSFETs in the present example is intended to be illustrative and non-limiting, such that in one or more other embodiments, other transistor types (e.g., a bipolar junction transistor (BJT)) may be used to implement one more of the transistors 120, 134, and 136.

The arrangement of the resonator 112, the capacitances 114 and 116, the transistor 120, and the resistance 122 may correspond to that of a Pierce oscillator. When supplied with electrical current (e.g., direct current) from the bias circuitry 128 via the node 126, the resonator 112 may be driven into oscillation. The resonator 112 and the capacitances 114 and 116 may form a pi network bandpass filter (e.g., with the resonator 112 acting as an inductive element), which provides a phase shift between the node 124 and the node 126. In this way, the oscillator circuitry 102 may generate a first oscillating signal at the node 124 and a second oscillating signal at the node 126, where the first oscillating signal is at or around 180 degrees out of phase with respect to the second oscillating signal. The oscillator circuitry 102 may generate the first oscillating signal at the node 124 at the same time the oscillator circuitry 102 generates the second oscillating signal at the node 126. That is, the first and second oscillating signals may be generated simultaneously.

The first conversion circuitry 104 may be implemented as a first alternating-current (AC) -coupled resistive feedback inverter. For example, the first conversion circuitry 104 may include a capacitance 140, an inverter 142, and a resistance 144. The capacitance 140 provides AC-coupling between the input of the inverter 142 and the node 126 (that is, between the input of the inverter 142 and the oscillator circuitry 102). The input of the inverter 142 may be connected to a node 141. Such AC-coupling may avoid an increase in the drive level of the resonator 112 that may otherwise be attributable to the first conversion circuitry 104 and the second conversion circuitry 106. The resistance 144 is coupled between the output of the inverter 142 and the input of the inverter 142. The resistance 144 may provide resistive feedback between the output of the inverter 142 and the input of the inverter 142.

The second conversion circuitry 106 may be implemented as a second AC-coupled resistive feedback inverter. For example, the second conversion circuitry 106 may include a capacitance 146, an inverter 148, and a resistance 150. The capacitance 146 provides AC-coupling between the input of the inverter 148 and the node 124, such the output of the second conversion circuitry is AC-coupled to the input of the inverter 148 and to the oscillator circuitry 102. Such AC-coupling may avoid an increase in the drive level of the resonator 112 that may otherwise be attributable to the second conversion circuitry 106. The resistance 150 is coupled between the output of the inverter 148 and the input of the inverter 148. The resistance 150 may provide resistive feedback between the output of the inverter 148 and the input of the inverter 148. An additional capacitance 174 may be coupled between the output of the inverter 148 of the second conversion circuitry 106 and the node 141 (i.e., the input of the inverter 142). The additional capacitance 174 may provide AC-coupling between the output of the second conversion circuitry 106 and both the input of the first conversion circuitry 104 and the oscillator circuitry 102, which may mitigate or avoid undesirable loading of the resonator 112 by the second conversion circuitry 106.

Circuitry 152 represents an example implementation of the first conversion circuitry 104, the second conversion circuitry 106, or both. For example, the circuitry 152 includes an input terminal 156, an output terminal 158, a capacitance 160, an intermediate node 162, a resistance 164, a transistor 166, and a transistor 168. The capacitance 160 is connected between the input terminal 156 and the intermediate node 162. The intermediate node 162 may correspond to the input of an inverter implemented by the transistors 166 and 168. The resistance is connected between the intermediate node 162 and the output terminal 518. The transistor 166 includes a source terminal coupled to a voltage supply 154, a gate terminal connected to the intermediate node 162, and a drain terminal connected to the output terminal 158. A capacitance 170 represents the gate-drain capacitance of the transistor 166. The transistor 168 includes a source terminal coupled to the reference node 118, a gate terminal connected to the intermediate node 162, and a drain terminal connected to the output terminal 158. A capacitance 172 represents the gate-drain capacitance of the transistor 168. In one or more embodiments the transistor 166 is a p-type MOSFET. In one or more embodiments, the transistor 168 is a n-type MOSFET. It should be understood that the depiction of the transistors 166 and 168 as MOSFETs in the present example is intended to be illustrative and non-limiting, such that in one or more other embodiments, other transistor types (e.g., a bipolar junction transistor (BJT)) may be used to implement one or both of the transistors 166 and 168.

In one or more embodiments in which the first conversion circuitry 104 is implemented using the circuitry 152, the node 141 may correspond to the node 162, the resistance 144 may be implemented as the resistance 164, the capacitance 140 may be implemented as the capacitance 160, and respective pull-up and pull-down transistors of the inverter 142 may be implemented as the transistors 166 and 168. In one or more embodiments in which the second conversion circuitry 106 is implemented using the circuitry 152, the resistance 150 may be implemented as the resistance 164, the capacitance 146 may be implemented as the capacitance 160, and respective pull-up and pull-down transistors of the inverter 148 may be implemented as the transistors 166 and 168.

In one or more embodiments, both the first conversion circuitry 104 and the second conversion circuitry 106 are both implemented using the same circuitry arrangement (e.g., that of the circuitry 152), where transistors used to implement the inverter 142 of the first conversion circuitry 104 may be of a different size (e.g., different total width and same or similar gate length, as a non-limiting example) compared to the transistors used to implement the inverter 148 of the second conversion circuitry 106.

The second conversion circuitry 106 may receive the first oscillating signal provided by the oscillating circuitry 102 via the node 124. The second conversion circuitry 106 may convert the first oscillating signal into a first square wave. The first square wave may be 180 degrees out of phase with respect to the first oscillating signal (e.g., due to the inverter 148). The second conversion circuitry 106 may provide the first square wave to the node 141 via the capacitance 174. The first square wave may be combined with the second oscillating signal at the node 126 to form a combined signal, and the combined signal may be provided to the input of the first conversion circuitry 104. The first conversion circuitry 104 may receive the combined signal via the node 126 and may convert the combined signal into a second square wave (e.g., thereby generating the second square wave). The second square wave may be 180 degrees out of phase with respect to the combined signal (e.g., due to the inverter 142). The first conversion circuitry 104 may provide the second square wave to the output node 108 of the signal generation circuitry 100 via the buffer circuitry 110.

Combining the first square wave produced by (e.g., generated by) the second conversion circuitry 106 with the second oscillating signal generated by the oscillating circuitry at the input of the first conversion circuitry 104 in this way reduces the kickback effect of the first conversion circuitry 104 on the input signal (e.g., which otherwise causes flattening of the at crossover points, as described further below) provided to the first conversion circuitry, thereby mitigating phase noise.

In one or more embodiments, the output node 108 may be coupled to a phase locked loop (PLL), such as an All-Digital PLL (ADPLL). In one or more such embodiments, the second square wave provided by the first conversion circuitry 104 via the output node 108 may act as a reference signal, such as a clock signal, for the PLL.

FIG. 2 shows a graph 200 representing an input signal 202 and an output signal 204 of square wave conversion circuitry included in reference signal generation circuitry that includes only that single square wave conversion circuitry between oscillator circuitry and the output of the reference signal generation circuitry. As shown, the input signal 202 is substantially sinusoidal, except for flattening that occurs at crossover points (e.g., the points in time at or around which the input signal 202 crosses over the output signal 204), where the pull-up and pull-down transistors of an inverter of the square wave conversion circuitry operate in their respective saturation regions at these cross-over points to provide maximum voltage gain. An enlarged view 206 further illustrates flattening of the input signal 202. This flattening of the input signal 202 results from a kickback effect attributable to high input capacitance of the square wave conversion circuitry. Because the phase noise at the output of an inverter is inversely proportional to the steepness of its input signal, the flattening of the input signal 202 undesirably limits the overall signal quality of the output signal 204. The input capacitance of the square wave conversion circuitry may be defined in the context of the Miller effect, as shown in Equation 1: ${C}_{in} = \left({C}_{gd , p}+{C}_{gd , n}\right) \times \left(1+\left|{A}_{ν}\right|\right)$

In Equation 1, *Cᵢₙ* represents the equivalent input capacitance of the square wave conversion circuitry, *C_{gd,p}* represents the gate-drain capacitance of the pull-up transistor of the inverter, *C_{gd,n}* represents the gate-drain capacitance of the pull-down transistor of the inverter, and *Aᵥ* represents the gain of the square wave conversion circuitry. The gain *Aᵥ* tends to be relatively large, particularly for applications involving reference clock signal generation, which typically require square waves with steep edges.

While it would appear that minimizing the length of the pull-up and pull-down transistors of the inverter of the square wave conversion circuitry to reduce *C_{gd,p}* and *C_{gd,n},* such a solution is typically only suitable for applications that are not sensitive to phase noise. This is because flicker noise from the pull-up and pull-down transistors of the inverter contributes to the overall phase noise, and minimizing the size of these transistors would result in excessive flicker noise contribution. Embodiments herein instead mitigate the input signal flattening illustrated in the present example by providing second square wave conversion circuitry (e.g., the square wave conversion circuitry 106 of FIG. 1) that is coupled between the oscillator circuitry and the first square wave conversion circuitry, where the square wave signal output by the second square wave conversion circuitry is combined with the signal output by the oscillator circuitry to increase the steepness of the rising and falling edges of the input signal provided at the input of the first square wave conversion circuitry.

FIG. 3 shows a graph 300 representing signals generated by an example embodiment of the signal generation circuitry 100 of FIG. 1, and is described here with reference to elements of the signal generation circuitry 100 of FIG. 1. The graph 300 includes an input signal 302 provided at an input of the first conversion circuitry 104, a first square wave 304 that is output by the second conversion circuitry 106, and an output signal 306 (sometimes referred to as a "second square wave 306") that is output by the first conversion circuitry 104.

The input signal 302 may be provided to the input of the first conversion circuitry 104 via the node 126. The input signal 302 may be a combination of the oscillating signal (e.g., sinusoidal signal) output by the oscillator circuitry 102 and the first square wave 304 output by the second conversion circuitry 106. Compared to the input signal 202 of FIG. 2, the input signal 302 has steeper slopes at its rising and falling edges due, at least in part, to the first square wave 304. An enlarged view 308 illustrates that flattening caused by the kickback effect is mitigated, relative to that of the input signal 202 of FIG. 2. Additionally, the mitigated flattening of the input signal 302 does not occur at the crossover points at which the input signal 302 crosses the output signal 306. Rather, the mitigated flattening of the input signal 302 is offset (with respect to time) from these crossover points. In this way, by providing the first square wave 304 to be combined with the oscillating signal output by the oscillator circuitry 102 to produce the input signal 302, phase noise in the output signal 306 is advantageously reduced.

FIG. 4 shows a graph 400 illustrating phase noise versus relative frequency (e.g., relative to the oscillation frequency), sometimes referred to as the "offset frequency," for a first curve 402 representing phase noise performance for the output signal (e.g., output square wave) of first signal generation circuitry having only a single set of square wave conversion circuitry, and a second curve 404 representing phase noise performance for the output signal (e.g., output square wave) of second signal generation circuitry (e.g., the signal generation circuitry 100 of FIG. 1) having two sets of square wave conversion circuitry (e.g., the first conversion circuitry 104 and second conversion circuitry 106 of FIG. 1) arranged in accordance with embodiments described herein. The phase noise comparison illustrated in the graph 400 is simulated using a 40 MHz crystal oscillator as the resonating element in each of the first and second signal generation circuitries, and takes into account noise from a low dropout (LDO) regulator and bias current.

As shown, from around 6 kHz to around 4 MHz, in terms of relative frequency, the phase noise performance of the first signal generation circuitry represented by the curve 402 is worse than the phase noise performance of the second signal generation circuitry represented by the curve 404. For example, the phase noise of the output signal of the second signal generation circuitry is around 5 dB less than that of the output signal of the first signal generation circuitry at 100 kHz. For example, the phase noise of the output signal of the second signal generation circuitry is around 2 dB less than that of the output signal of the first signal generation circuitry at 1 MHz.

Various exemplary embodiments are presented below. Some simplifications and omissions may be made in the following examples, which are intended to highlight and introduce some aspects of the various exemplary embodiments, without limiting the scope.

In an example embodiment, signal generation circuitry includes oscillator circuitry configured to generate a first oscillating signal at a first node and generate a second oscillating signal at a second node, first square wave conversion circuitry having a first input coupled to the second node and having a first output coupled to an output of the signal generation circuitry, and second square wave conversion circuitry having a second input coupled to the first node and a second output coupled to the second node, the second square wave conversion circuitry being configured to generate a first square wave based on the first oscillating signal. The first square wave and the second oscillating signal are combined at the second node to produce a combined signal. The first square wave conversion circuitry is configured to generate a second square wave based on the combined signal.

In one or more embodiments, the first square wave conversion circuitry includes a first resistive feedback inverter that is alternating-current (AC)-coupled to the second node via a first capacitance.

In one or more embodiments, the second square wave conversion circuitry includes a second resistive feedback inverter that is AC-coupled to the first node via a second capacitance.

In one or more embodiments, the second square wave conversion circuitry is AC-coupled to the second node via a third capacitance.

In one or more embodiments, the oscillator circuitry includes a resonator coupled between the first node and the second node, a first capacitance coupled between the first node and a reference node, a second capacitance coupled between the second node and the reference node,

a first transistor having a gate terminal connected to the first node and a drain terminal connected to the second node, and a resistance coupled between the first node and the second node.

In one or more embodiments, the oscillator circuitry is arranged as a Pierce oscillator.

In one or more embodiments, the oscillator circuitry further includes bias circuitry connected to the second node, the bias circuitry including a current mirror including a second transistor and a third transistor, a current source coupled to the second transistor, and a low-pass filter coupled between the second transistor and the third transistor. The third transistor is connected to the second node.

In one or more embodiments, the output of the signal generation circuitry is coupled to a phase locked loop (PLL), and the second square wave is provided to the PLL as a reference clock signal for the PLL.

In an example embodiment, a method includes generating, by oscillator circuitry, a first oscillating signal and a second oscillating signal, generating, by second square wave conversion circuitry, a first square wave based on the first oscillating signal, and generating, by first square wave conversion circuitry, a second square wave based on the first square wave and the second oscillating signal.

In one or more embodiments, the method further includes combining the first square wave and the second oscillating signal at an input of the first square wave conversion circuitry to produce a combined signal. Generating the second square wave includes generating, by the first square wave conversion circuitry, the second square wave based on the combined signal.

In one or more embodiments, the first square wave conversion circuitry includes a first resistive feedback inverter that is alternating-current (AC)-coupled to the oscillator circuitry.

In one or more embodiments, the second square wave conversion circuitry includes a second resistive feedback inverter that is AC-coupled to the oscillator circuitry and that is AC-coupled to the first square wave conversion circuitry.

In one or more embodiments, the first and second oscillating signals are generated simultaneously.

In one or more embodiments, the oscillating circuitry includes a Pierce oscillator.

In an example embodiment, signal generation circuitry includes first square wave conversion circuitry including a first input and a first output, and second square wave conversion circuitry including a second input and a second output, the second output being coupled to the first input of the first square wave conversion circuitry, and the second square wave conversion circuitry being configured to generate a first square wave based on a first oscillating signal received at the second input. The first square wave and a second oscillating signal are combined to produce a combined signal. The first square wave conversion circuitry is configured to generate a second square wave based on the combined signal.

In one or more embodiments, the signal generation circuitry includes oscillator circuitry configured to simultaneously generate the first oscillating signal at a first node coupled to the second input of the second square wave generation circuitry and generate the second oscillating signal at a second node coupled to the first input of the first square wave generation circuitry.

In one or more embodiments, the first square wave conversion circuitry includes a first resistive feedback inverter that is alternating-current (AC)-coupled to the second node via a first capacitance, the second square wave conversion circuitry includes a second resistive feedback inverter that is AC-coupled to the first node via a second capacitance. The second square wave conversion circuitry is AC-coupled to the second node via a third capacitance.

In one or more embodiments, the oscillator circuitry includes a resonator coupled between the first node and the second node, a first capacitance coupled between the first node and a reference node, a second capacitance coupled between the second node and the reference node, a first transistor having a gate terminal connected to the first node and a drain terminal connected to the second node, and a resistance coupled between the first node and the second node.

In one or more embodiments, the oscillator circuitry further includes bias circuitry connected to the second node, the bias circuitry including a current mirror including a second transistor and a third transistor, a current source coupled to the second transistor, and a low-pass filter coupled between the second transistor and the third transistor. The third transistor is connected to the second node.

In one or more embodiments, the output of the signal generation circuitry is coupled to a phase locked loop (PLL), and the second square wave is provided to the PLL as a reference clock signal for the PLL.

As used herein the terms "circuit" and "circuitry," including the term "processing circuitry" and related terminology means any suitable combination(s) of analog or digital circuit elements, hardware, firmware, software, and the like; including but not limited to, application-specific integrated circuits (ASICs), field programmable gate arrays (FPGAs), microcontrollers, and microprocessors. It will be understood that the term "circuitry" encompasses nonvolatile and volatile memory devices including, but not limited to random access memory (RAM), read-only memory (ROM), and the like, which can be implemented using any suitable devices, such as SRAM, DRAM, or magnetic storage devices as non-limiting examples.

While at least one exemplary embodiment has been presented in the foregoing detailed description, it should be appreciated that a vast number of variations exist. It should also be appreciated that exemplary embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. Signal generation circuitry comprising:
oscillator circuitry configured to:
generate a first oscillating signal at a first node; and
generate a second oscillating signal at a second node;
first square wave conversion circuitry having a first input coupled to the second node and having a first output coupled to an output of the signal generation circuitry; and
second square wave conversion circuitry having a second input coupled to the first node and a second output coupled to the second node, the second square wave conversion circuitry being configured to generate a first square wave based on the first oscillating signal,
wherein the first square wave and the second oscillating signal are combined at the second node to produce a combined signal, and wherein the first square wave conversion circuitry is configured to generate a second square wave based on the combined signal.

2. The signal generation circuitry of claim 1, wherein the first square wave conversion circuitry comprises a first resistive feedback inverter that is alternating-current, AC,-coupled to the second node via a first capacitance.

3. The signal generation circuitry of claim 2, wherein the second square wave conversion circuitry comprises a second resistive feedback inverter that is AC-coupled to the first node via a second capacitance.

4. The signal generation circuitry of claim 3, wherein the second square wave conversion circuitry is AC-coupled to the second node via a third capacitance.

5. The signal generation circuitry of any preceding claim, wherein the oscillator circuitry comprises:
a resonator coupled between the first node and the second node;
a first capacitance coupled between the first node and a reference node;
a second capacitance coupled between the second node and the reference node;
a first transistor having a gate terminal connected to the first node and a drain terminal connected to the second node; and
a resistance coupled between the first node and the second node.

6. The signal generation circuitry of claim 5, wherein the oscillator circuitry is arranged as a Pierce oscillator.

7. The signal generation circuitry of claim 5 or 6, wherein the oscillator circuitry further comprises bias circuitry connected to the second node, the bias circuitry comprising:
a current mirror comprising a second transistor and a third transistor;
a current source coupled to the second transistor; and
a low-pass filter coupled between the second transistor and the third transistor, wherein
the third transistor is connected to the second node.

8. The signal generation circuitry of any preceding claim, wherein the output of the signal generation circuitry is coupled to a phase locked loop, PLL, and the second square wave is provided to the PLL as a reference clock signal for the PLL.

9. A method comprising:
generating, by oscillator circuitry, a first oscillating signal and a second oscillating signal;
generating, by second square wave conversion circuitry, a first square wave based on the first oscillating signal; and
generating, by first square wave conversion circuitry, a second square wave based on the first square wave and the second oscillating signal.

10. The method of claim 9, further comprising:
combining the first square wave and the second oscillating signal at an input of the first square wave conversion circuitry to produce a combined signal, wherein generating the second square wave comprises:
generating, by the first square wave conversion circuitry, the second square wave based on the combined signal.

11. The method of claim 10, wherein the first square wave conversion circuitry comprises a first resistive feedback inverter that is alternating-current (AC)-coupled to the oscillator circuitry.

12. The method of claim 11, wherein the second square wave conversion circuitry comprises a second resistive feedback inverter that is AC-coupled to the oscillator circuitry and that is AC-coupled to the first square wave conversion circuitry.

13. The method of any of claims 9 to 12, wherein the first and second oscillating signals are generated simultaneously.

14. The method of any of claims 9 to 13, wherein the oscillating circuitry comprises a Pierce oscillator.
